# EUROPEAN PATENT APPLICATION

(11) **EP 3 929 540 A1**
(43) Date of publication of application: **29.12.2021**
(21) Application number: 20182659.1
(22) Date of filing: 26.06.2020
(51) Int. Cl.: G01D 11/30, G01H 11/08, G01L 1/16

(54) **ATTACHMENT SYSTEM FOR ATTACHING A SENSOR TO A SUBSTRATE, METHOD OF ATTACHING A SENSOR TO A SUBSTRATE**

(71) Applicant: TE Connectivity Norge AS, 5258 Blomsterdalen (NO)
(72) Inventor: Aadland, Harald, 5221 Nesttun (NO); Boe, Yngve, 5223 Nesttun (NO)
(74) Representative: Grünecker Patent- und Rechtsanwälte PartG mbB

(57) **Abstract**

The document shows an attachment system (100) for attaching a sensor (20) to a substrate (30), comprising a first layer (11) of adhesive adapted for attaching the sensor (20) and a second layer (12) of adhesive adapted for attaching the substrate (30), wherein the first layer (11) is attached to the second layer (12), and wherein the first layer (11) differs from the second layer (12) in at least one of elasticity and hardness. Further, shown is a method of attaching a sensor (20) to a substrate (30), comprising the step of attaching a first layer (11) of adhesive to the sensor (20), the step of attaching a second layer (12) of adhesive to the substrate (30) and the step of attaching the first layer (11) of adhesive to the second layer (12) of adhesive, wherein the first layer (11) differs from the second layer (12) in at least one of elasticity and hardness.

## Description

The invention relates to an attachment system for attaching a sensor to a substrate and a method of attaching a sensor to a substrate.

Often, sensor that are attached to a substrate develop fractures if subjected to varying temperatures.

The object of the invention is thus to provide a solution where the risk of a fracture in the sensor is minimized or avoided.

This object is achieved with an attachment system for attaching a sensor to a substrate, comprising a first layer of adhesive adapted for attaching the sensor and a second layer of adhesive adapted for attaching the substrate, wherein the first layer is attached to the second layer, and wherein the first layer differs from the second layer in at least one of elasticity and hardness.

A corresponding method of attaching a sensor to a substrate comprises the step of attaching a first layer of adhesive to the sensor, the step of attaching a second layer of adhesive to the substrate and the step of attaching the first layer of adhesive to the second layer of adhesive, wherein the first layer differs from the second layer in at least one of elasticity and hardness.

Due to the differences in at least one of the elasticity and the hardness, the attachment system can compensate for differences in the thermal expansion coefficients on the two sides, while still allowing a secure mounting.

The solution according to the invention can further be improved by the following further developments and advantageous embodiments which are independent of each other and can be combined arbitrarily, as desired.

The first layer can differ from the second layer in the elasticity and/or the hardness by at least 3%, preferably at least 5%, more preferably at least 10%, in particular at least 20%, especially at least 40%. This helps to increase the compensating effect and to thus provide a more stable sensor assembly. In particular for the elasticity, the difference can be much higher, for example more than 100%, more than 200% or more than 1000%.

In an advantageous embodiment, the first layer can have a higher hardness and/or a lower elasticity than the second layer. This can be useful when the sensor has a low thermal expansion coefficient, while the substrate has a high thermal expansion coefficient.

To facilitate the connection of two different materials, the first layer can differ from the second layer in adhesion properties. The adhesion mechanism for the first layer can be different from the adhesion mechanism for the second layer. Possible adhesion mechanisms are mechanical adhesion, for example a positive locking, chemical bonding, physical bonding, van-der-Waals-bonding, electrostatic bonding or diffusive bonding.

Further, the first layer can differ from the second layer in curing properties. A curing mechanism for the first layer can be different from a curing mechanism for the second layer. For example, one layer, in particular the second layer, can have a compression curing mechanism, while the other layer could have an optic, accelerator, heat, or anaerobe curing mechanism.

In order to keep the forces low, when thermal expansion takes place, at least one of the first layer and the second layer can be viscoelastic. The viscous part of the viscoelastic response does not give a force and thus does not put any stress on the attached materials.

Preferably, at least one of the first layer and the second layer is flexible. This can facilitate the adaptation to the material to which the layer is attached. Preferably, the second layer is flexible, in order to adapt to a substrate that for example is also flexible or has a higher thermal expansion coefficient.

The other one of the first layer and the second layer can be stiff. This can help to provide a mechanical stability to the attachment system. Further, such stiff material can for example be better suitable for the transmission of signals or be easier to mount.

In a preferred embodiment, one of the first layer and the second layer is solid and the other layer is viscos or viscoelastic. This achieves a good compromise between compensation effect and mechanical stability.

Preferably, the first layer is solid. This can additionally help to stabilise the sensor.

The adhesive of the viscous layer can be tacky or sticky, to allow a good attachment while providing the compensation effect.

The solid layer can be smooth, in particular it can be attachable to a smooth surface. The solid layer can be sheet-like. The solid layer can have a constant thickness.

The attachment system can be adapted for attaching the sensor to a side of the first layer that is opposite a side where the second layer is attached. The first layer can thus be sandwiched between the sensor and the second layer. This can result in a compact design.

Further, the attachment system can be adapted for attaching the substrate to a side of the second layer that is opposite to a side, to which the first layer is attached. The second layer can thus be sandwiched between the first layer and the substrate. This can also result in a compact design.

In a semi-mounted state, the attachment system can further comprise the sensor. Such an attachment system can then be mounted to further elements, in particular to the substrate. The sensor can in particular be attached to the layer with the higher hardness and/or the lower elasticity.

In a different semi-mounted state, the attachment system can further comprise the substrate. Such an attachment system can be mounted to the sensor in a subsequent step. In particular, the substrate can be attached to the layer with the lower hardness and/or the higher elasticity.

In a preferred embodiment, a sensor assembly comprises a sensor, a substrate and an attachment system according to the invention.

The sensor can comprise a piezo element. Such a piezo element can be brittle and fragile. The use of the inventive attachment system is particular advantageous in such a case.

The sensor can be an ultrasound sensor. In addition to the improved thermal performance, the ultrasound sensor can also be decoupled at least partially by the inventive attachment system, so that the ultrasound performance is also improved.

In order to allow a repeated attachment and detachment in an easy manner, the sensor assembly can further comprise an intermediate element located between the attachment system and the sensor.

Preferably, the intermediate element is attached to the sensor with a further layer of adhesive. In order to keep the internal stresses low, the further layer of adhesive preferably corresponds in elasticity and/or hardness to the layer of adhesive of the attachment system that is adapted for attaching the sensor.

In a preferred embodiment of the method, the step of attaching the first layer to the second layer is performed before the steps of attaching the first layer to the sensor and attaching the second layer to the substrate. This can simplify the mounting process.

In order to simplify production, the step of attaching the first layer to the second layer can be performed when at least one of the layers is supported on a carrier structure. Such a carrier structure can be a film or a foil.

The method can further comprise the step of removing the carrier structure from the first or second film after the first layer has been attached to the second layer. This can in particular improve the performance of the sensor. The carrier structure can prefereably be removed when the attachment system has been attached to the sensor and/or the substrate, in order to use the stabilizing effect of the carrier structure during the step of attaching the attachment system to the sensor or substrate, respectivly.

It is also advantageous when the material for the first layer and/or the second layer is selectively chosen to achieve an attachment system according to the invention. The materials can in particular be chosen such that the first layer and the second layer adhere to each other and that each of the layers adheres to the material to which it is to be attached.

The relative thicknesses of the layers can be chosen to achieve a stability with one layer, while maintaining the compensation effect of the other layer.

In particular if a layer is hard or a solid, it can have a thermal expansion coefficient that is adapted to the thermal expansion coefficient of the material to which it is to be attached. "Adapted to" can in particular mean that the thermal expansion coefficient does not differ by more than 1%, 2%, 3%, 5% or 10% in order to avoid a breaking. In other embodiments, the difference in the thermal expansion coefficients between the layer and the material to which it is attached can differ, if this is for example compensated for with the elasticity or viscosity of one of the layer or the material.

The first layer can differ from the second layer in the thermal expansion coefficient by at least 3%, preferably at least 5%, more preferably at least 10%, in particular at least 20%, especially at least 40%. The differences can even be much higher for example greater than 100 %, 200 % or 500 %.

The elasticity and the hardness of the layers only has to be different in a plane parallel to the layers, to allow a compensation of the thermal expansion. In many cases, the elasticity and hardness in a direction perpendicular to the plane are not critical. However, for many materials, the elasticity and the hardness of the layers are isotropic and in particular equal in the directions parallel and perpndicular to the plane.

Further, the difference in the elasticity and/or the hardness should be present in the attached state. In this state, the adhesives are cured.

Elasticity here has to be understood as the ability to respond to a deformation without breaking. Possible concepts for describing this can use Young's modulus for describing the stiffness, the shear modulus for describing the reaction to a shear force, or the bulk modulus for describing the reaction to a compressive strain. Parameters that can be used to describe the elasiticity can include in particular Young's modulus up to the yield strength, i. e. the point where the material starts to deform or break under the strain.

Hardness is to be understood as the ability to withstand mechanical forces and to provide mechanical stability. A parameter that can be used for measuring the hardness can be Rockwell, for example HRA or HRB. Standards for the measurements can for example be taken from ISO 6508-1, ISO 6508-2: ISO 6508-3, or ISO 2039-2. Alternative parameters for can be Vickers hardness or Brinell hardness.

According to the invention, a mechanically stable adhesive is combined with an adhesive that can take up the thermal expansion without being damaged.

The invention will now be described in greater detail and in an exemplary manner, using advantageous embodiments and with reference to the drawings. The described embodiments are only possible configurations in which, however, the individual features as described above can be provided independently of one another or can be omitted.

In the Figures:
- Fig. 1: shows a schematic sectional view of a first embodiment of an attachment system, together with a sensor and a substrate;
- Fig. 2: shows a schematic sectional view a second embodiment of an attachment system;
- Fig. 3: shows a schematic perspective view of a first step of a method of producing an attachment system;
- Fig. 4: shows a schematic perspective view of a second step of a method of producing an attachment system;
- Fig. 5: shows a schematic perspective view of a third step of a method of producing an attachment system;
- Fig. 6: shows a schematic perspective view of the result of the method according to Figs. 3, 4 and 5;
- Fig. 7: shows a schematic sectional view of an attachment system produced with the method according to Figs. 3,4 and 5.

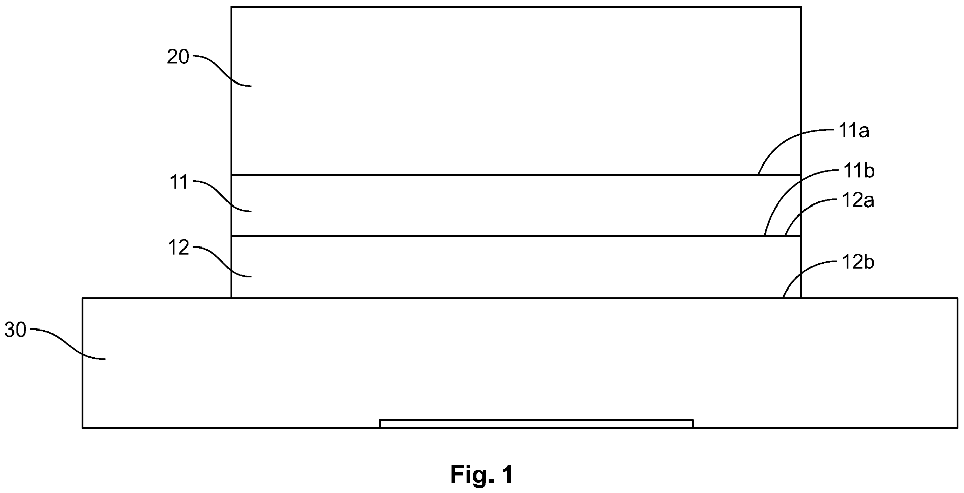

In Fig. 1, a first embodiment of an attachment system 100 is shown connected to a sensor 20 and a substrate 30.

The attachment system 100 for attaching the sensor 20 to the substrate 30 comprises a first layer 11 of adhesive, adapted for attaching the sensor 20 and a second layer 12 of adhesive, adapted for attaching the substrate 30, wherein the first layer 11 is attached to the second layer 12, and wherein the first layer 11 differs from the second layer 12 at least in one of elasticity and hardness. Further, the first layer 11 can differ from the second layer 12 in the curing properties or the curing mechanism.

Such an attachment system 100 reduces the risk that the sensor 20 breaks when the temperature changes, for example during a thermal test cycling or during operation.

In the depicted example, the first layer 11 is rather hard and provides stability, while the second layer 12 is elastic, for example tacky, and takes up the thermal expansion that the substrate 30 shows when the temperature is increased. The first layer 11 and the sensor 20 can have a thermal expansion coefficient that is much lower than the thermal expansion coefficient of the substrate 30. The high elasticity of the second layer 12 compensates this difference without leading to a fracture in either of the components.

If a layer 11, 12 is hard or a solid, it can have a thermal expansion coefficient that is adapted to the thermal expansion coefficient of the material to which it is to be attached. "Adapted to" can in particular mean that the thermal expansion coefficient does not differ by more than 1%, 2%, 3%, 5% or 10% in order to avoid a breaking. In other embodiments, the difference in the thermal expansion coefficients between the layer 11, 12 and the material to which it is attached can differ, if this is for example compensated for with the elasticity or viscosity of one of the layers 11, 12 or the material.

The first layer 11 can differ from the second layer 12 in the elasticity and/or the hardness by at least 3%, preferably at least 5%, more preferably at least 10%, in particular at least 20%, especially at least 40%. In particular for the elasticity, the difference can be much higher, for example more than 100%, more than 200% or more than 1000%.

The first layer 11 can differ from the second layer 12 in the thermal expansion coefficient by at least 3%, preferably at least 5%, more preferably at least 10%, in particular at least 20%, especially at least 40%. The differences can even be much higher for example greater than 100 %, 200 % or 500 %.

To allow the connection of two different materials, the first layer 11 can differ from the second layer 12 in adhesion properties. The adhesion mechanism for the first layer 11 can be different from the adhesion mechanism for the second layer 12. Possible adhesion mechanisms are mechanical adhesion, for example a positive locking, chemical bonding, physical bonding, van-der-Waals-bonding, electrostatic bonding or diffusive bonding.

Moreover, the first layer 11 can differ from the second layer 12 in curing properties. A curing mechanism for the first layer 11 can be different from a curing mechanism for the second layer 12. For example, one layer, in particular the second layer 12 , can have a compression curing mechanism, while the other layer could have an optic, accelerator, heat, or anaerobe curing mechanism.

In order to keep the forces low, when thermal expansion takes place, at least one of the first layer 11 and the second layer 12 can be viscous or viscoelastic. In the depicted example, for example the second layer 12 is viscoelastic. The viscous part of the viscoelastic response does not result in a force and thus does not put any stress on the attached materials.

Preferably, at least one of the first layer 11 and the second layer 12 is flexible. This can facilitate the adaptation to the material to which the layer 11, 12 is attached. In the example of Fig. 1, the second layer 12 is flexible, in order to adapt to a substrate 30 that has for example a higher thermal expansion coefficient.

The other one of the first layer 11 and the second layer 12 can be stiff. This can help to provide a mechanical stability to the attachment system 100. Further, such a stiff material can for example be better suitable for the transmission of signals or be easier to mount.

The first layer 11 is solid and the second layer 12 is viscos or viscoelastic. This achieves a good compromise between compensation effect and mechanical stability.

The adhesive of the viscous second layer 12 can be tacky or sticky, to allow a good attachment while providing the compensation effect.

The solid, first layer 11 can be smooth, in particular to be attachable to a smooth surface of the sensor 20. The solid, first layer can be sheet-like. The solid layer can have a constant thickness.

The attachment system 100 is adapted for attaching the sensor 20 to a first side 11a of the first layer 11 that is opposite a second side 11b, where the second layer 12 is attached. The first layer 11 is sandwiched between the sensor 20 and the second layer 12. This results in a compact design.

Further, the attachment system 100 is adapted for attaching the substrate 30 to a second side 12b of the second layer 12 that is opposite a first side 12a at which the first layer 11 is attached. The second layer 12 is sandwiched between the first layer 11 and the substrate 30. This also results in a compact design.

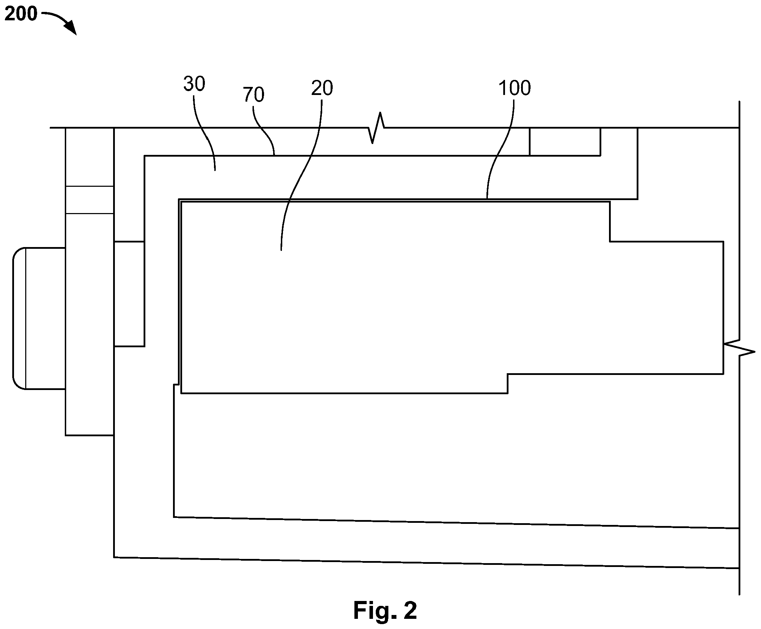

In Fig. 2, a second embodiment of an attachment system 100 is shown in a sensor assembly 200. The sensor assembly 200 comprises a sensor 20 that could be an ultrasound sensor and comprise a piezo element. A signal can leave through a measurement window 70. As the piezo element is brittle and fragile, the use of the attachment system 100 is particular advantageous.

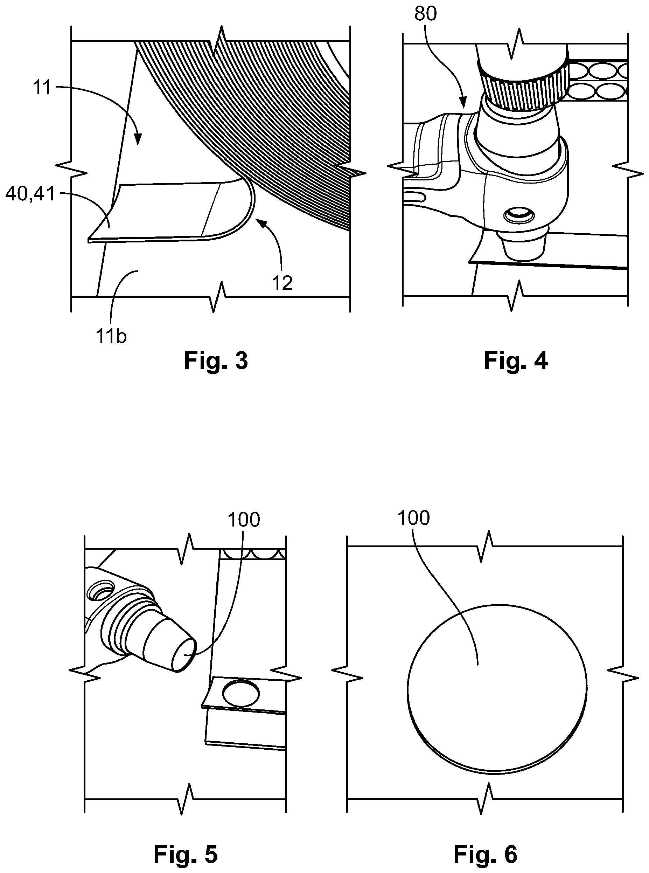

In Figs. 3 to 7, steps of the production of an attachment system 100 and the resulting attachment system 100 are shown.

In the first step, shown in Fig. 3, the second layer 12 of adhesive, which is supplied from a role, is joint to the first layer 11 of adhesive in the form of a sheet. The second layer 12 and the first layer 11 are pressed against each other, to achieve an intimate contact.

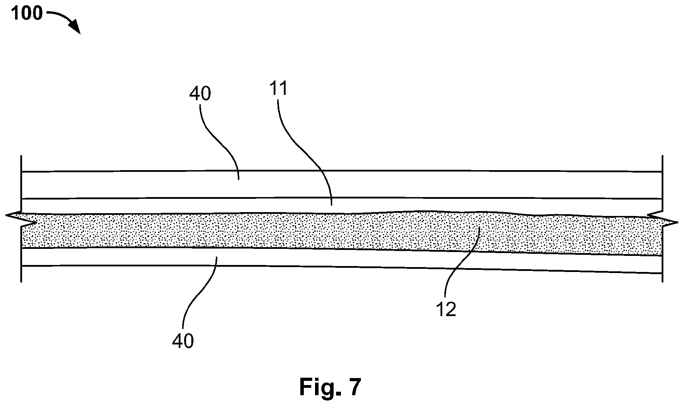

In the second step, shown in Fig. 4, a part of the double layer structure is cut out by using a punching tool 80. The resulting attachment system 100 is then removed from the cavity of the punching tool 80 (Fig. 5) and can be used. In the depicted example, the attachment system 100 has a planar circular shape, as can be seen in Fig. 6. However, other shapes are of course possible. In the cross-sectional view of Fig. 7, the structure of the attachment system 100 can be seen,

Figs. 3 and 4 also show parts of a method for attaching a sensor 22 to a substrate 30. In particular, these figures show the step of attaching the first layer 11 to the second layer 12, which is performed before the steps of attaching the first layer 11 to the sensor 20 and attaching the second layer 12 to the substrate 30.

In order to allow a simple production, the step of attaching the first layer 11 to the second layer 12 is performed when at least one of the layers 11, 12 is supported on a carrier structure 40. The carrier structure 40 is in this case a film 41 or a foil.

The method can further comprise the step of removing the carrier structure 40 from the first or second layer 11, 12 after the first layer 11 has been attached to the second layer 12.

In a semi-mounted state, that is not explicitly depicted, the attachment system 100 as produced by the steps shown in Figs. 3 to 6 can further comprise the sensor 20. Such an attachment system 100 can then be mounted to further elements, in particular to the substrate 30. The sensor 20 can in particular be attached to the layer with higher hardness and/or lower elasticity.

In a different semi-mounted state, that is also not explicitly depicted, the attachment system 100 as produced by the steps shown in Figs. 3 to 6 can further comprise the substrate 30. Such an attachment system 100 can be mounted to the sensor 20 in a subsequent step. In particular, the substrate 30 can be attached to the layer with the lower hardness and/or the higher elasticity.

The materials for the first layer 11 and/or the second layer 12 are selectively chosen to achieve an attachment system 100 according to the invention. The materials have in particular to be chosen such that the first layer 11 and the second layer 12 adhere to each other and that each of the layers 11, 12 adheres to the material to which it is to be attached.

The thicknesses of the layers 11, 12 can be chosen to achieve a stability with one layer while maintaining the compensation effect of the other layer. The thickness of the layer with higher hardness and/or lower elasticity can be greater by a factor of at least 2, preferably by a factor of at least 3, especially by a factor of at least 5 than the thickness of the other layer. In other embodiments, the thickness of the layer with lower hardness and/or higher elasticity can be greater by a factor of at least 2, preferably by a factor of at least 3, especially by a factor of at least 5 than the thickness of the other layer.

In particular, if a layer 11, 12 is hard or a solid, it can have a thermal expansion coefficient that is adapted to the thermal expansion coefficient of the material to which it is to be attached. "Adapted to" can in particular mean that the thermal expansion coefficient does not differ by more than 1%, 2%, 3%, 5% or 10%, in order to avoid a breaking.

The elasticity and the hardness of the layers only has to be different in a plane parallel to the layers 11, 12, to allow a compensation of the thermal expansion. In many cases, the elasticity and hardness in a direction perpendicular to the plane is not critical. However, in most materials the properties are equal along the two directions.

Further, the difference in the elasticity and/or the hardness should be present in the attached state. In this state, the adhesives are cured.

Elasticity here has to be understood as the ability to respond to a deformation without breaking. Possible concepts for describing this can use Young's modulus for describing the stiffness, the shear modulus for describing the reaction to a shear force, or the bulk modulus for describing the reaction to a compressive strain. Parameters that can be used to describe the elasticity can include in particular Young's modulus up to the yield strength, i.e. the point where the material starts to deform or break under the strain.

Hardness is to be understood as the ability to withstand mechanical forces and to provide mechanical stability.

The inventive solution could also be used for the attachment of other devices or structures. For example, a first substrate could be attached to a second substrate.

According to the invention, a mechanically stable adhesive is combined with an adhesive that can take up the thermal expansion without being damaged.

### Reference Numerals

- 11: first layer
- 11a: first side
- 11b: second side
- 12: second layer
- 12a: first side
- 12b: second side
- 20: sensor
- 30: substrate
- 40: carrier structure
- 41: film
- 70: measurement opening
- 80: punching tool
- 100: attachment system
- 200: sensor assembly

## Claims

1. Attachment system (100) for attaching a sensor (20) to a substrate (30), comprising a first layer (11) of adhesive adapted for attaching the sensor (20) and a second layer (12) of adhesive adapted for attaching the substrate (30), wherein the first layer (11) is attached to the second layer (12), and wherein the first layer (11) differs from the second layer (12) in at least one of elasticity and hardness.

2. Attachment system (100) according to claim 1, wherein the first layer (11) has a higher hardness and/or a lower elasticity.

3. Attachment system (100) according to claim 1 or 2, wherein the first layer (11) differs from the second layer (12) in adhesion properties.

4. Attachment system (100) according to one of claims 1 to 3, wherein the first layer (11) differs from the second layer (12) in curing properties.

5. Attachment system (100) according to one of claims 1 to 4, wherein at least one of the first layer (11) and the second layer (12) is viscoelastic.

6. Attachment system (100) according to one of claims 1 to 5, wherein one of the first layer (11) and the second layer (12) is solid and the other one is viscos or viscoelastic.

7. Attachment system (100) according to one of claim 1 to 6, further comprising the sensor (20).

8. Attachment system (100) according to one of claim 1 to 7, further comprising the substrate (30).

9. Sensor assembly (200) comprising a sensor (20), a substrate (30) and an attachment system (100) according to one of claims 1 to 6.

10. Sensor assembly (200) according to claim 9, wherein the sensor (20) comprises a piezo element.

11. Sensor assembly (200) according to one of claims 9 or 10, wherein the sensor assembly (200) further comprises an intermediate element located between the attachment system (100) and the sensor (20).

12. Method of attaching a sensor (20) to a substrate (30), comprising the step of attaching a first layer (11) of adhesive to the sensor (20), the step of attaching a second layer (12) of adhesive to the substrate (30) and the step of attaching the first layer (11) of adhesive to the second layer (12) of adhesive, wherein the first layer (11) differs from the second layer (12) in at least one of elasticity and hardness.

13. Method according to claim 12, wherein the step of attaching the first layer (11) to the second layer (12) is performed before the steps of attaching the first layer (11) to the sensor (20) and attaching the second layer (12) to the substrate (30).

14. Method according to one of claims 12 or 13, wherein the step of attaching the first layer (11) to the second layer (12) is performed when at least one of the layers is supported on a carrier structure (40).
